(19) **Europäisches Patentamt European Patent Office Office européen des brevets**

(11) **EP 4 722 740 A1**

(12) **EUROPEAN PATENT APPLICATION**

(43) Date of publication:
08.04.2026 Bulletin 2026/15

(21) Application number: 25151916.1

(22) Date of filing: 15.01.2025

(51) International Patent Classification (IPC):
*G01R 19/25* (2006.01)     *G01R 31/08* (2020.01)
*G01R 31/52* (2020.01)

(52) Cooperative Patent Classification (CPC):
**G01R 31/086; G01R 19/2513; G01R 31/085;
G01R 31/088; G01R 31/52;** H02H 1/0092;
H02J 13/12

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 04.10.2024 US 202418907015

(71) Applicant: **Eaton Intelligent Power Limited
Dublin D04 Y0C2 (IE)**

(72) Inventors:
• **MENG, Xiangying
Troy (US)**

• **CHANDRA, Souvik
Littleton (US)**
• **TALUKDER, Soumyabrata
Littleton (US)**
• **ZHANG, Jinan
Lakewood (US)**
• **ISHCHENKO, Dmitry
Cary (US)**
• **NOWAK, Michael
Milwaukee (US)**

(74) Representative: **Schwan Schorer & Partner mbB
Patentanwälte
Bauerstraße 22
80796 München (DE)**

(54) **HIGH IMPEDANCE FAULT LOCATION IN ELECTRIC POWER DISTRIBUTION SYSTEMS**

(57) A method for locating a high impedance fault event location in a distribution system is provided. The method includes determining a topology ranking for sensors in a distribution system. The topology refers to the arrangement of sensors with respect to one another in network. The topology ranking represents a number of steps from a power source to a sensor with respect to the direction of current flow The method further includes receiving an alarm at a central processor indicating a high impedance fault event, transmitting a request for data associated with the high impedance fault event to the plurality of sensors and a plurality of edge processing devices in the distribution system, receiving the requested data from the edge processing devices and determining a relative location of the high impedance fault event with respect to one of the plurality of sensors using the requested data and the topology ranking.

FIG. 2B

EP 4 722 740 A1

**Description**

Statement Regarding Government Funding:

This invention was made with government support under CBMESSR, 8155.23.GV project, contract number W9132T-22-C-0026. The Federal Government has certain rights to this invention.

Technical Field

The present disclosure relates to systems, methods and devices for locating and isolating high impedance faults in electric power distribution systems, in particular, in radial power systems.

BACKGROUND

Catastrophic wildfires often lead to the loss of life and extensive property damage. Electric power distribution systems are also damaged by wildfires which result in power outages within the electrical power distribution system. Increasing prevalence of wildfires may be attributed to rising temperatures, population growth, and water shortages.
Traditional fault location techniques estimate the fault location based on the measured impedance magnitude, voltage drop from fault location to source, network model or application of traveling wave strategy in transmission lines. Advanced machine learning methods have been implemented for high impedance ("HiZ") fault localization. One method uses wavelet transformation of voltage signals and support vector machine (SVM), and another method combines artificial neural networks with frequency spectral characteristics of post-fault measurements.

BRIEF SUMMARY

In accordance with the present disclosure, fault location systems, devices and methods locate the positions of HiZ faults in electric power distribution systems based on characteristics of HiZ faults and topology information of the distribution systems. Locating HiZ faults quickly minimizes the cost of HiZ fault damage, mitigates risks associated with HiZ faults, and aids in maintaining power coverage to other regions of the distribution system.
A method for locating a high impedance fault event location in a distribution system includes the steps of: determining a topology ranking for each of a plurality of sensors in a distribution system; receiving an alarm at a central processor indicating a high impedance fault event; transmitting a request for data associated with the high impedance fault event to the plurality of edge processing devices in the distribution system; receiving the requested data from the edge processing devices; and determining a relative location of the high impedance fault event with respect to one of the plurality of sensors using the requested data and the topology ranking.
A radial power system includes at least one power source, a plurality of sensors, a plurality of edge devices, and a central processor. Each of the plurality of sensors is positioned at a unique location within the radial power system and calculates harmonic energy values based on detected electrical signals. Each of the plurality of edge processing devices is connected to at least one sensor and configured to detect a high impedance fault event within the radial power system based on the harmonic energy values received from the sensors. The central processor is connected to the plurality of edge processing devices. The central processor is configured to determine a relative location of the high impedance fault event in the radial power system using a topology ranking for each of the plurality of sensors.
This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

BRIEF DESCRIPTION OF THE DRAWINGS

FIG. 1 illustrates a schematic system diagram for a distribution network;
FIG. 2A illustrates an operating environment for a distribution network;
FIG. 2B illustrates a process flow diagram for a distribution network;
FIG. 3 illustrates a method for determining a relative location of a high impedance fault in a distribution network;
FIGS. 4A to 4E illustrate variables used to determine the relative location of a high impedance fault in a distribution network;
FIG. 5A illustrates a topology of a distribution network having a plurality of nodes;
FIG. 5B illustrates a directed graph of the plurality of nodes shown in Fig. 5A after sorting;

EP 4 722 740 A1

**FIG. 5C** illustrates a chart of topology rankings for each sensor;

**FIG. 6** illustrates a method of sorting a topology of a distribution network;

**FIGS. 7A to 7E** illustrate harmonic values over time for a plurality of sensors in a distribution network;

**FIGS. 8A to 8E** illustrate voltage over time for a plurality of sensors in a distribution network;

**FIG. 9A** illustrates a topology of a distribution network having a plurality of nodes;

**FIG. 9B** illustrates a schematic diagram of the plurality of nodes shown in Fig. 9A after sorting;

**FIG. 9C** illustrates a chart of topology rankings for each sensor;

**FIGS. 10A to 10C** illustrate harmonic values over time for a plurality of sensors in a distribution network; and

**FIG. 11** illustrates a central processing unit for a distribution network.

DETAILED DESCRIPTION

Approximately 30% of wildfire hazards in electric power distribution systems are linked to downed conductors, overhead lines contacting vegetation, and conductor slapping in medium-voltage overhead lines. These events may lead to high impedance faults in the distribution system. A high impedance fault ("HiZ") occurs when an energized electrical conductor comes into contact with a highly resistive object, such as a tree, structure, or the ground, and a large impedance limits the flow of electrical current in the distribution system. HiZ faults are a major concern in medium-voltage overhead distribution systems with voltages below 70 kV. These faults are transient and, unlike typical ground faults, do not produce substantial currents that trip standard over-current protection devices in distribution systems.

Traditional fault location techniques may be significantly affected by factors such as fault type, unbalanced loads, and heterogeneity of overhead lines. In addition, these techniques do not consider the topology of the distribution systems. Topology varies from one distribution network to another, and topology varies within a distribution network when, for example, the direction of current flow changes due to adding or removing power sources at different locations in the network and/or opening and closing breakers. The change in topology can impact the accuracy of machine learning based fault location technology.

Mitigating risks associated with HiZ faults in distribution systems has been a longstanding issue for utility providers. The rapid growth of distributed energy resources ("DER") in distribution systems has made the detection of HiZ faults more challenging because the DER may cause changes in system topology when the DER are connected or disconnected to the systems. Additionally, DERs can lead to back feeding the grid, essentially changing current flow in the grid without any change in breaker status. DERs are often integrated through inverters, which can produce harmonics leading to false alarms for HiZ fault detection. Thus, a reliable and accurate HiZ fault location system is needed to locate HiZ faults in power systems.

In accordance with the present disclosure, fault location systems, devices and methods locate the positions of HiZ faults in electric power distribution systems based on characteristics of HiZ faults and topology information of the distribution systems. Locating HiZ faults quickly minimizes the cost of HiZ fault damage, mitigates risks associated with HiZ faults, and aids in maintaining power coverage to other regions of the distribution system.

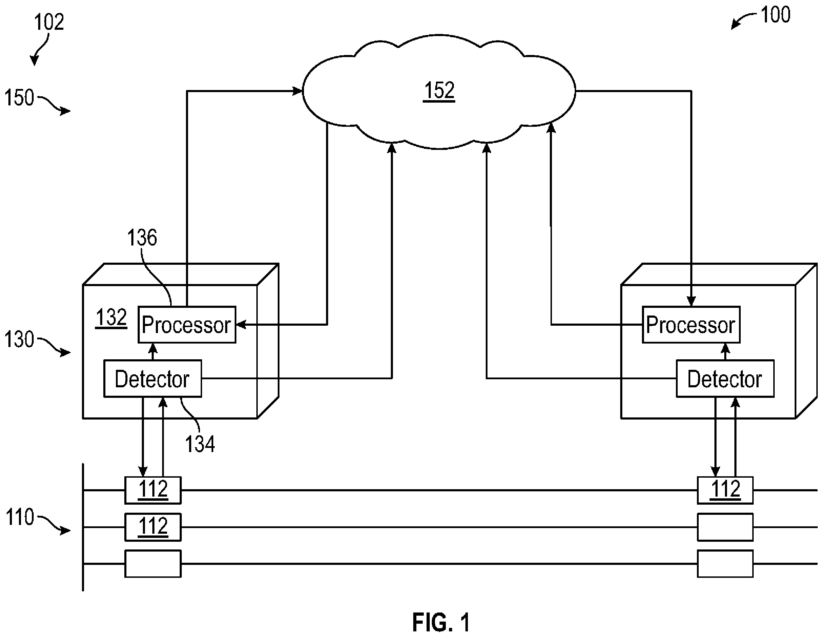

**FIG. 1** illustrates a schematic system diagram for a distribution network **100** having a system architecture **102.** System architecture **102** includes three layers, a first layer **110,** a second layer **130** and a third layer **150.** Each layer is in direct or indirect communication with the other layers providing an internet of things (IoT) framework with an edge-cloud/central processor system. Third layer **150** includes a cloud or central processor **152,** second layer **130** includes a plurality of edge devices **132** and first layer **110** includes a plurality of sensors **112.** As illustrated in **FIG. 1,** sensors **112** are in communication with edge devices **132.** Sensors **112** are located throughout distribution network **100** at unique locations; sensors **112** may be located on a variety of components or nodes including power sources, loads, power lines, and breakers and may include smart devices. Edge devices **132** are in communication with sensors **112** and central processor **152.** Edge devices **132** have computing power, perform calculations and collect and process data from sensors **112** and central processor **152.** In various implementations, edge devices **132** include processors **136** and detectors **134** for processing, computing and calculating. Edge computing in the second layer **130** of system architecture **102** reduces the amount and type of data that needs to be sent to central processor **152** which reduces data transfer, increases processing speeds and reduces stress on central processor **152.** Central processor **152** maintains and processes system wide knowledge from the plurality of edge devices **132** and sensors **112** to control distribution network **100.**

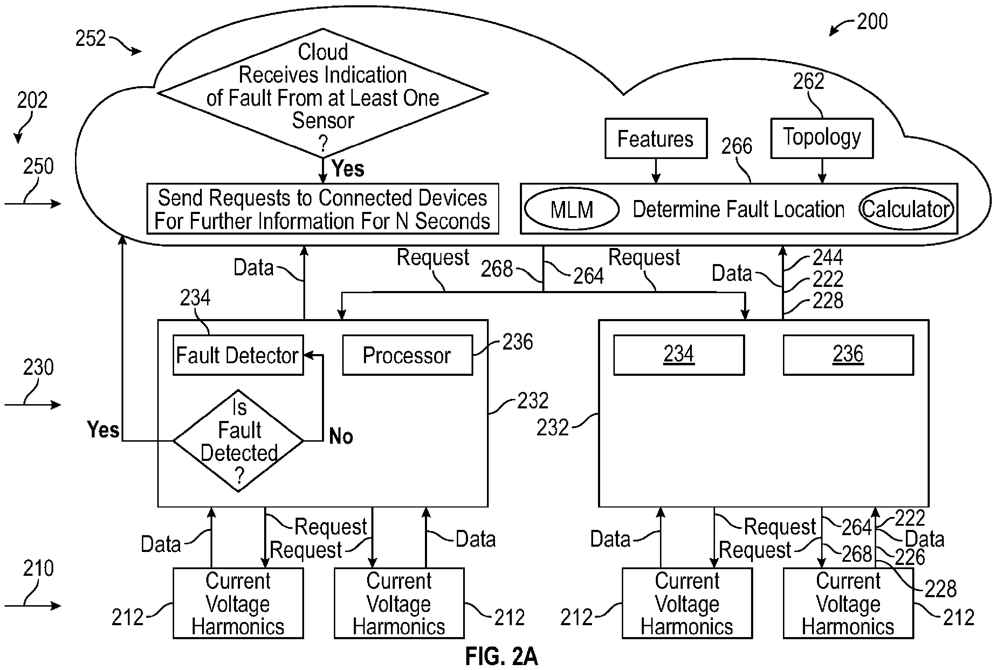

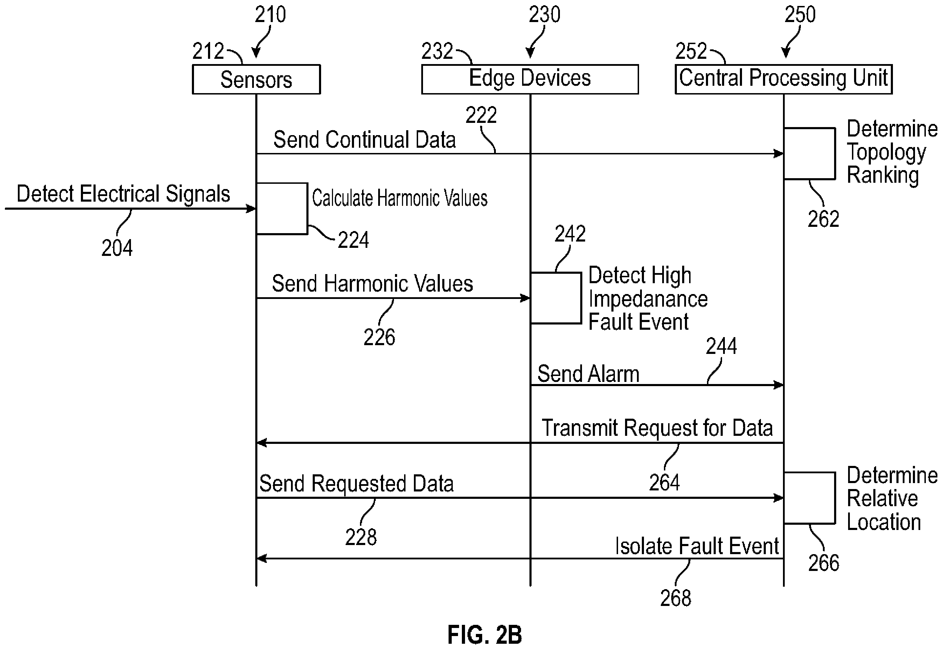

**FIG. 2A** illustrates an operating environment and **FIG. 2B** illustrates a process flow diagram for a distribution network **200.** Distribution network **200** includes a system architecture **202** having three layers, a first layer **210,** a second layer **230** and a third layer **250.** System architecture **202** includes an edge-cloud framework. First layer **210** includes a plurality of sensors **212** on nodes at different locations throughout distribution network **200.** Second layer **230** includes edge processing devices **232,** each edge processing device **232** is in communication with at least one sensor in first layer **210.** Third layer **250** includes cloud/central processor **252** for controlling distribution network **200.** Cloud/central processor **252** directly communicates with edge processing devices **232** and indirectly communicates with sensors **212** via second layer **230.**

First layer **210** transmits data to second and third layers **230, 250** and receives requests and commands from second and third layers **230, 250**. In accordance with the present disclosure, sensors **212** transmit data: (a) to edge processing devices **232** for detecting a HiZ fault event; (b) to cloud/central processor **252** for determining topology rankings; and (c) to cloud/central processor **252** for locating a HiZ fault event. As an example, topology information can be learnt from data such as current direction and RMS magnitudes of currents and voltages from each sensor. The sensors talk to cloud/central processor **252** through SCADA (Supervisory Control and Data Acquisition) communication where such data is normally available.

Sensors **212** are located on various nodes and power lines throughout distribution network **200**. In one implementation, distribution network **200** may be a residential electric power system in which nodes include power sources, loads (homes), and breakers. Sensors **212** detect transient electrical signals **204** such as current and voltage signals including current direction, current amplitude, current magnitude, and breaker status (*e.g.*, open or closed) and process the electrical signals to obtain time series data. Sensors **212** transmit this data to edge processing devices **232** and cloud/central processor **252**.

Sensors **212** transmit time series data or harmonic energy values derived therefrom to edge processing devices **232** continuously or at frequent intervals for detection of HiZ fault events. In some implementations, sensors **212** calculate harmonic energy values **224** from the time series data and send the harmonic energy values **226** to edge processing devices **232**. In other implementations, sensors **212** transmit time series data and edge processing devices **232** process the time series data to obtain harmonic energy values. If, for example, the sensors **212** have enough computational resources, the calculation of harmonic energy values can be done in at the first level **210**. Otherwise, the calculation of harmonic energy values can be done at the second level **230**. In some cases, the sensors **212** may even have enough computational power to run a HiZ detection algorithm to detect a HiZ fault event. Otherwise, the harmonic energy values are used by edge processing devices **232** to detect a HiZ fault event which will be discussed in more detail below.

In addition, sensors **212** continually transmit data **222** to third layer **250** via second layer **230** so cloud/central processor **252** can determine topology rankings **262** for each sensor **212** in network **200**. Sensors **212** continually transmit data, for example, current direction, current amplitude, and breaker status, to cloud/central processor **252** because a change in the direction of current flow in network **200** may change the topology rankings of some or all of sensors **212**. This data may be sent repeatedly, every five seconds or so, for example. To reduce the amount of data sent to cloud/central processor **252**, sensors **212** and/or edge processing devices **232** may transmit current direction, current amplitude, and breaker status data to cloud/central processor **252** for initial topology ranking determinations and transmit data thereafter when a change in the data (current direction, current amplitude, or breaker status) occurs. In this way, the amount of data sent to cloud/central processor **252** may be reduced resulting in less stress on network **200**.

Sensors **212** also transmit data to second and third layers **230, 250** upon request. Cloud/central processor **252** transmits a request for data **264** from sensors **212** across distribution network **200** when a HiZ fault event has been detected by an edge device **232**. Cloud/central processor **252** requests information regarding several variables including, for example, current timeseries data or voltage timeseries data. From the current timeseries data or voltage time series data, the cloud/central process can compute variables such as detection time, detection duration, and mean harmonic amplitude changes for high fidelity events (128 or 256 samples per power cycle or 16 ms or a fidelity of 125 microseconds). In other cases, variables such as detection time, detection duration, and mean harmonic amplitude changes can be requested by cloud/central processor **252** directly from the second layer **230**. Sensors **212** receive the request and send the requested data **228** to cloud/central processor **252** for processing.

Second layer **230** receives data from first layer **210** and transmits data to and receives requests and commands from third layer **250**. In accordance with the present disclosure, edge processing devices **232**: (a) detect HiZ fault events based on data received from sensors **212**; (b) send alarms to cloud/central processor **252** when HiZ fault events are detected; and (c) transmit and receive requests, commands and data between sensors **212** and cloud/central processor **252**.

Edge processing devices **232** include a robust computing platform capable of implementing full or in part the HiZ detection algorithms, examples of which are disclosed in PCT Application Nos. PCT/EP2024/063777 and PCT/EP2024/063756 which are incorporated herein by reference. In some cases, the edge processing device **232** runs a part of the HiZ detection algorithm while the remaining portion is performed by cloud/central processor **252**. Edge processing devices **232** input harmonic energy values received from sensors **212** into the HiZ detection algorithms to continuously monitor network **200** for HiZ fault events. In various implementations, edge processing devices **232** receive time series data from sensors **212** and process the time series data to obtain the harmonic energy values that are subsequently input into the algorithms. Harmonic energy values of the third or fifth harmonic value may be input into the algorithms. Individual low order harmonics, odd, even or interharmonics may be input into the algorithms.

A HiZ fault event is detected when changes in certain characteristics of harmonic values occur. When a HiZ fault event is detected in one of the edge processing devices **232,** that particular edge processing device **232** sends an alarm **244** to cloud/central processor **252** alerting cloud/central processor **252** to the HiZ fault event. In response, cloud/central processor **252** transmits a request for additional data **264** to connected device in first and second layers **210, 230,** *i.e.*, edge processing devices **232** and sensors **212.** In reply to the data request, sensors **212** send the requested data **228** to cloud/central processor **252** via edge processing devices **232.**

As illustrated in **FIG. 2A,** edge processing devices **232** include a fault detector **234** and a processor **236.** Fault detector **234** and processor **236** are shown as distinct boxes for illustrative purposes only. In various implementations, the functions may be carried out by the same, overlapping, or disjointed hardware as needed or desired.

Third layer **250** is in communication with first layer **210** and second layer **230.** In accordance with the present disclosure, cloud/central processor **252**: (a) determines a topology ranking for each sensor **212** in the network **200;** (b) determines the location of a HiZ fault event using the topology ranking in combination with requested data from sensors **212** and edge processing devices **232;** and (c) sends a command to isolate the HiZ fault event.

Cloud/central processor **252** transmits requests to all edge devices **232** for data when a HiZ fault event is detected by any edge device **232.** In accordance with the present disclosure, cloud/central processor **252** determines a topology ranking for each sensor **212** in the network **200.** When cloud/central processor **252** receives data from one of the edge devices **232** that a HiZ fault event has been detected, central processor **252** locates the position of the HiZ fault event using the topology ranking and data received from sensors **212.** Cloud/central processor **252** isolates the HiZ fault event by sending a command **268** to open a corresponding breaker or set of breakers that are the closest to and located upstream of the HiZ fault event location to de-energize the HiZ fault thereby lowering the risk of fire at the location of the HiZ fault event and lowering damage and power failures throughout network **200.**

The three layers **210, 230, 250** of system architecture **202** provide an accelerated response time from HiZ fault event detection by edge devices **232** to de-energization by cloud/central processor **252.** By quickly locating the HiZ fault event using system-wide knowledge of the affected areas of network **200,** the correct breaker or set of breakers can be opened to mitigate risks to the network **200.**

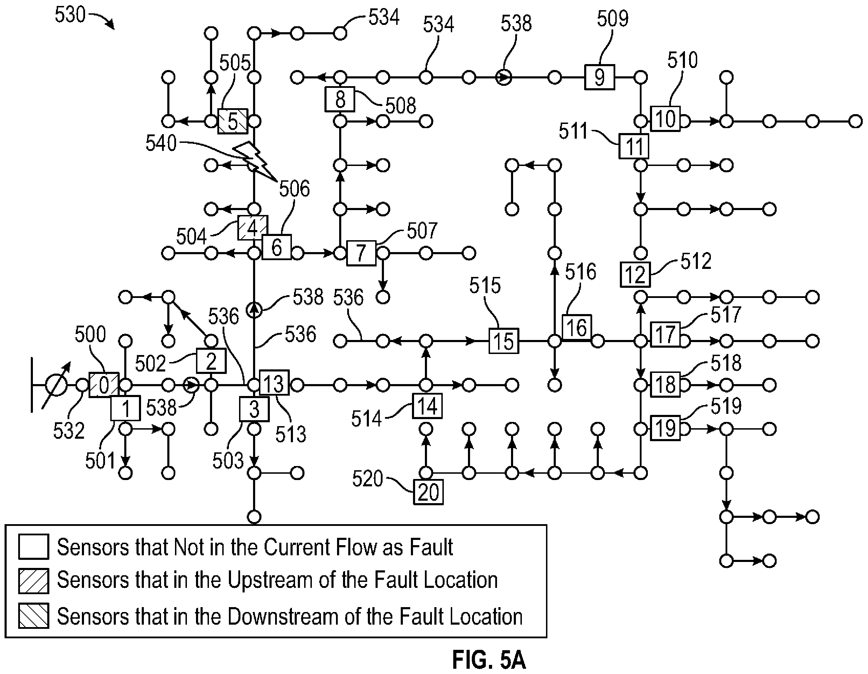

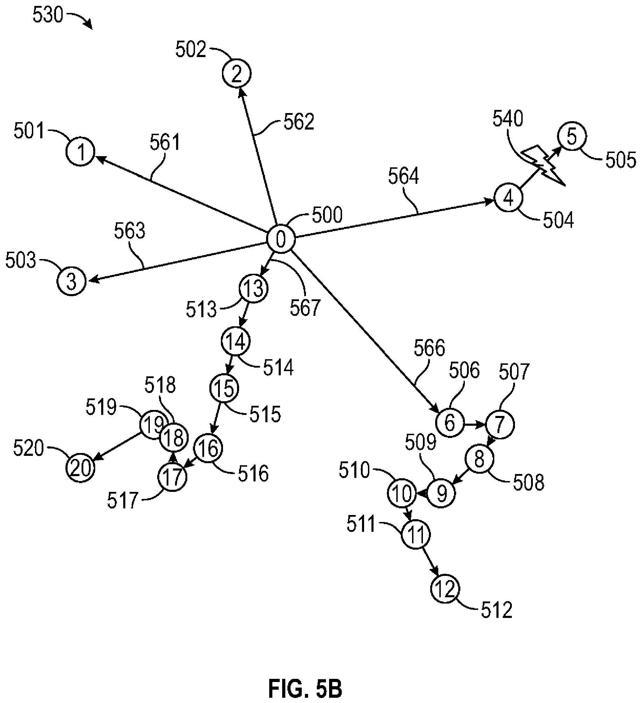

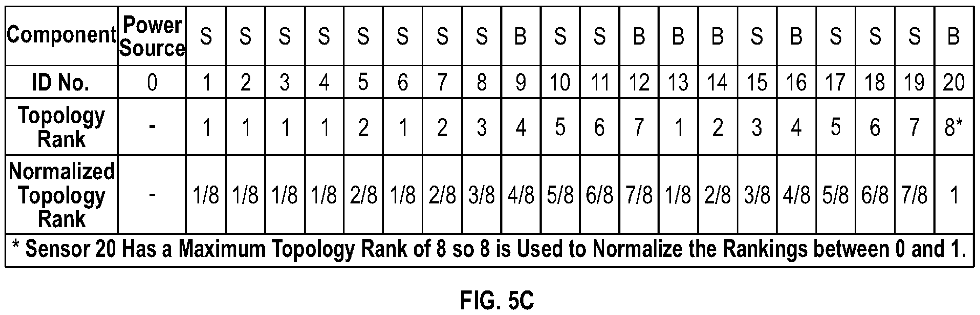

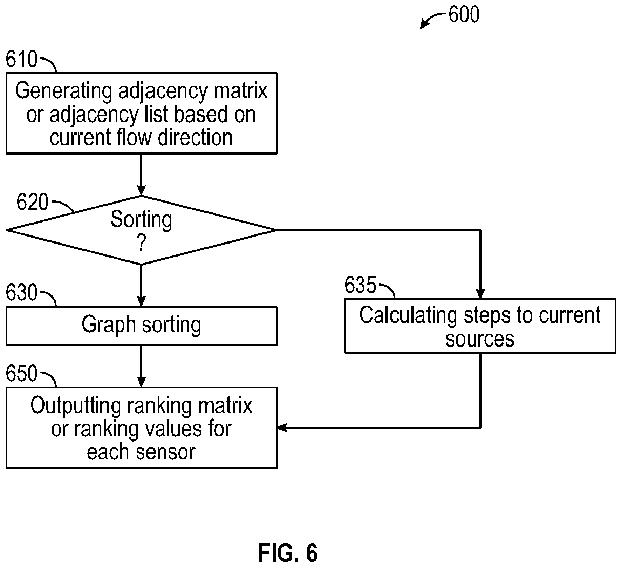

As explained above, sensors **212** continually send data to cloud/central processor **252** regarding current direction, current amplitude, and breaker status so a topology of the distribution network **200** can be considered when a location of a HiZ fault event needs to be ascertained. The topology refers to the arrangement of sensors **212** with respect to one another in network **200** and will be further explained below with reference to **FIGS. 5A, 5B, 5C and 6.** Cloud/central processor **252** determines an initial topology ranking for each sensor **212** based on a direction of current flow in network **200.** The initial topology rankings are updated in real-time when the direction of current flow in network **200** changes. The direction of current flow may change as power sources are taken on or off the network and/or when breakers are opened or closed, for example. Thus, cloud/central processor **252** maintains an accurate mapping of the topology of the network **200** in real-time.

When cloud/central processor **252** receives an alarm indicating a HiZ fault event has been detected in an edge processing device **232,** cloud/central processor **252** transmits a request for data **264** to all connected devices in first layer **210** and second layer **230,** specifically sensors **212** and edge processing devices **232.** Cloud/central processor **252** requests data for variables over an upcoming given period of time including, for example, detection time, detection duration, and mean harmonic amplitude changes, because these variables are associated with a location of a HiZ fault event. Sensors **212** close to a HiZ fault event location generally have greater amplitude changes in harmonic energy values, earlier detection (detection time) and longer detection duration, *i.e.*, the changes in amplitude last longer. The given period of time may begin immediately or as quickly as possible and be a few seconds long, for example, 2 to 3 seconds of time. Providing a short time period reduces the amount of data transmission across network **200** and quickly enables cloud/central processor **252** to determine the location of the HiZ fault event and mitigate risks associated therewith.

In accordance with the present disclosure, a location metric *f* determines which sensor **212** is the closest upstream sensor to the HiZ fault location, thus providing the relative location of the HiZ fault event with respect to a location of a sensor **212** in network **200.** Sensors **212** are encoded with physical location data so the corresponding physical location of the HiZ fault event can also be determined. Cloud/central processor **252** determines a final HiZ fault event location by determining a maximum value of location metric *f* using Equation (1) below (Calculator) or using a machine learning model (MLM) using a binary classification model or a multi-classification model including logistic regression, random forest, or decision tree.

$$\textbf{Eq (1)} \qquad f = HiZ\ detection\ status \times \sqrt{mean\ harmonics} \times \frac{1}{detection\_time} \times$$

$$detection\ duration \times topology\ ranking^2$$

The variables of Eq (1) correlated to a HiZ fault location include a HiZ detection status, mean harmonic amplitude change ("mean harmonics"), detection time, detection duration and topology ranking. The HiZ detection status is a binary number between 0 and 1, *i.e.*, 0 or 1. A value of 0 indicates no detection of a HiZ fault event in the corresponding edge processing device, whereas a value of 1 signifies a detected HiZ fault event in the edge processing device. Thus, if only one edge processing device detects a HiZ fault event, the sensors connected to that edge processing device will have location metric $f$ values greater than 0, whereas the remaining sensors that are connected to other edge processing devices will have location metric values $f$ equal to 0 because the HiZ detection status is 0 when no HiZ fault event was detected. Consequently, computing is done quickly for the remaining sensors.

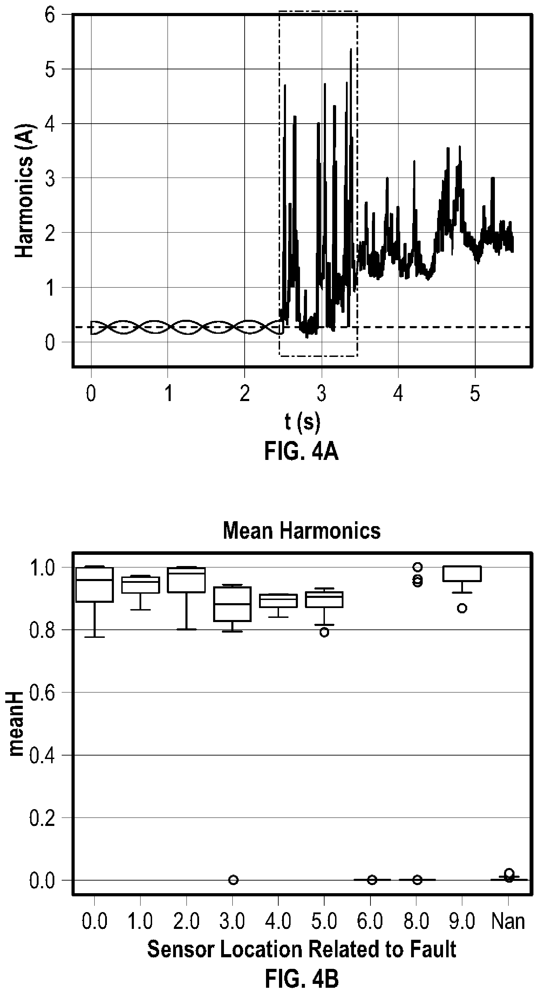

Mean harmonic amplitude change denotes the mean value of the change in amplitude of the harmonic energy values with respect to a baseline amplitude within a given period of time. For example, as shown in **FIG. 4A,** the change in the amplitude of the baseline harmonics occurs between 2 and 2.5 seconds. The baseline amplitude is less than 0.5A prior to the change and increases sharply to a high of nearly 5.5A. For use in Eq (1), the mean harmonic amplitude change values are normalized between 0 and 1. To normalize the values, the mean harmonic amplitude change for each sensor is determined and the maximum value is used as denominator. Each mean harmonic value is divided by the denominator, resulting in mean Harmonic values between 0 and 1. **FIG. 4B** illustrates normalized mean harmonic values between 0 and 1 for a plurality of sensors relative to the steps from the sensors to the fault location. For example, if a sensor is not in the same branch as the fault, the number of steps to the fault is represented on the x-axis as Nan.

Detection time is the time a HiZ fault event is first detected by the sensor relative to an initial start time. The initial start time will be the request time from the central processor minus a buffer time. Since the value of Eq(1) is proportional to 1/Detection time, here we use detection time to represent the value of 1/Detection time. The detection time for the sensors that don't detect HiZ fault event is 0. Detection time is also normalized for use in Eq (1), each detection time is divided by the maximum detection time. Maximum detection time is a time with respect to an initial start time. For example, the request time from the central processor is 4:00PM. As there is a buffer to record a certain duration of data, e.g., 5 sec of data pre-request, the start time will be 3:55PM. If the fault is detected at 4:02 PM by the sensor, the detection time of the sensor will be 7 sec. The maximum detection time will be the maximum value over all the sensors that detect the HiZ fault.

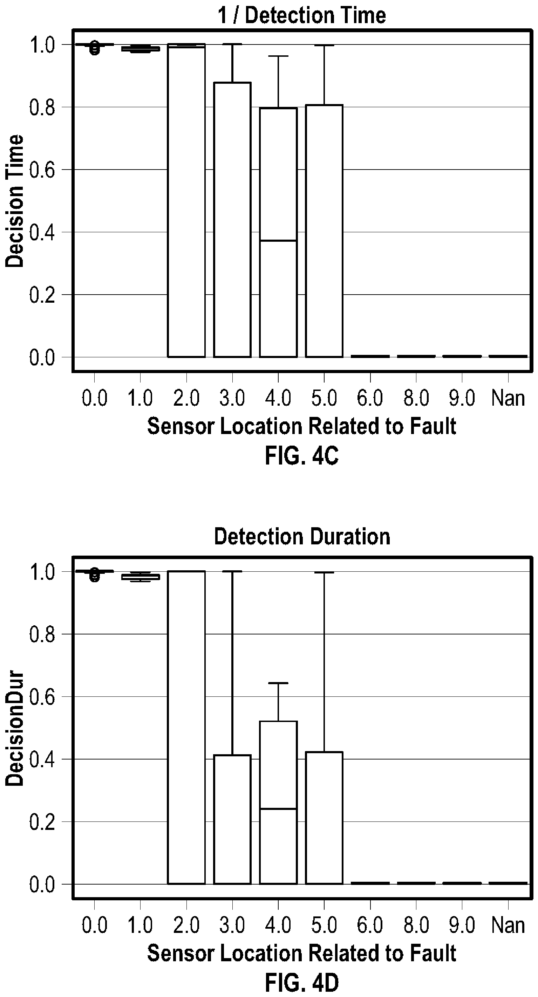

Detection duration refers to the duration of time for which a HiZ fault event is consistently detected within a defined window of time. Detection duration values are normalized for use in Eq (1) by dividing each detection duration value by the maximum detection duration value resulting in normalized values between 0 and 1. **FIG. 4D** illustrates normalized decision duration values between 0 and 1 for a plurality of sensors relative to the steps from the sensors to the fault location.

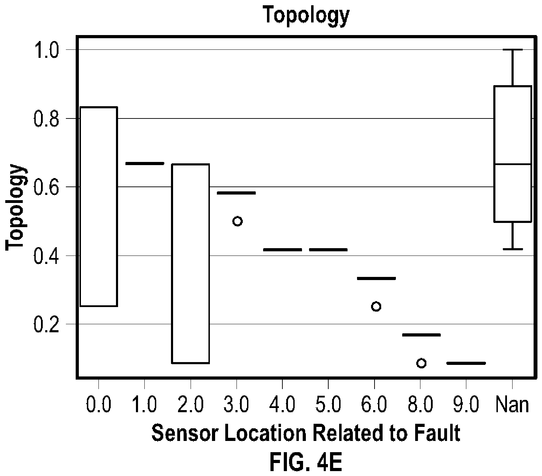

Topology ranking represents a number of steps from a power source to a sensor with respect to the direction of current flow. Topology ranking values are normalized for use in Eq (1). The number of steps from a power source to each sensor is determined. The maximum number of steps from a power source to the furthest sensor is identified. Each number of steps is divided by the maximum number of steps resulting in normalized values between 0 and 1. **FIG. 4E** illustrates normalized topology ranking values between 0 and 1 for a plurality of sensors. Topology ranking will be further explained below with respect to **FIGS. 5A, 5B, 5C and 6.**

Once cloud/central processor **252** has the requested data **228** from first and second layers **210, 230,** cloud/central processor **252** processes the data to determine a relative location of the HiZ fault event **266** with respect to one of the sensors **212** in network **200** using Eq (1) or a machine learning model. Upon locating the HiZ fault event, cloud/central processor **252** can isolate the HiZ fault event by opening the nearest upstream breaker. Opening the nearest upstream breaker prevents current from flowing into the HiZ fault event and mitigates risks associated therewith.

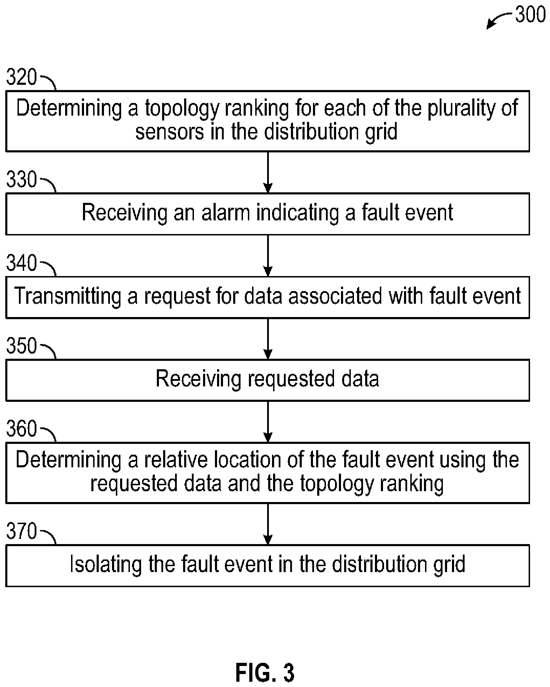

FIG. 3 illustrates a method **300** for determining a relative location of a high impedance fault in a distribution grid having a central processing unit, a plurality of edge devices and a plurality of sensors as illustrated in **FIG. 1.** A central processing unit, for example, a central processor, a server or a cloud determines **(320)** a topology ranking for each of the plurality of sensors in the distribution grid using data received from a plurality of sensors in the grid. The topology ranking represents the number of steps from a power source to a sensor with respect to a direction of current flow. The topology rankings may be updated when the power source and/or direction of current flow changes in the grid. Central processing unit receives **(330)** an alarm indicating that a HiZ fault event has been detected. In response to the alarm, central processing unit transmits **(340)** a request for data associated with the HiZ fault event to the connected devices in the grid, *e.g.,* the edge devices and sensors, for more detailed information for an upcoming given period of time, *e.g.,* for the next two or three seconds. The requested data may include a HiZ detection status, mean harmonic amplitude changes, detection times, and detection durations. Once the central processing unit receives **(350)** the requested data, the central processor determines **(360)** a relative location of the HiZ fault event using the topology ranking and the requested data to identify the nearest upstream sensor, that is, the sensor with the highest location metric value $f$. Central processing unit then isolates **(370)** the HiZ fault event in the distribution grid by sending a command to open the nearest upstream breaker in order to prevent current from flowing to the HiZ fault event location.

FIGS. 4A to 4E illustrate variables used to determine the relative location of a high impedance fault in a distribution network. **FIG. 4A** illustrates harmonic energy values over time for a sensor in a distribution network. **FIG. 4B** illustrates normalized values for mean harmonic amplitude changes for a plurality of sensors with respect to a fault location. **FIG. 4C** illustrates normalized values for detection time for a plurality of sensors with respect to a fault location. **FIG. 4D** illustrates normalized values for detection duration for a plurality of sensors with respect to a fault location. **FIG. 4E** illustrates normalized values for topology ranking for a plurality of sensors with respect to a fault location.

FIG. 5A illustrates a topology of a distribution network having a plurality of nodes, **FIG. 5B** illustrates a schematic diagram of a plurality of sensors shown in **FIG. 5A** after sorting and **FIG. 5C** is a chart illustrating topology rankings and normalized topology rankings for each sensor.

Topology refers to a network of components in an electrical power distribution system and the power lines that connect the components with each other. A system with radial topology includes components connected in series with each other starting at a power source. Power lines, including overhead power lines and underground cables, emanating from the power source connect various components throughout the distribution system. The topology refers to a plot of the pathways from the source to the different components. The components in an electrical power distribution system may include sensors, breakers, transformers, power lines, loads (*e.g.*, homes, businesses, consumer end users), power sources including substations and transformers, and distributed energy resources ("DER") (*e.g.,* solar panels). A system with radial topology does not include closed loops and is often described as a tree with branches.

Electrical power distribution systems exhibit diverse topologies, which can significantly affect fault detection. In accordance with the present disclosure, topology information including a relative location of a sensor and the current flow direction is used to locate a HiZ fault event in the distribution system.

Topology information for each distributed system is based on current flow direction. The topology information of each sensor is encoded into a ranking variable or ranking matrix using adjacency sets. The adjacency sets contain pairs of nodes that have direct current flow from one to another. A directed graph is used to order the sensors in the electrical power distribution system. Each sensor represents a vertex. When current flows directly from sensor A to sensor B, an edge is established from A to B, A→B, such that vertex A comes before B in the ordering. The adjacency sets can be dynamically generated from current flow direction information from a SCADA system or other current direction measurement devices.

Sensors can be sorted using traditional graph sorting techniques or calculating the distance to current sources. To calculate the distance to current sources, the number of steps from a sensor upstream to a power source are counted with respect to the direction of current flow. Each power source has its own distance vector. The distance to current sources for each sensor is output as a ranking matrix or ranking values.

If there is no closed loop inside the power distribution system, the present disclosure is effective for use in systems with multiple power sources. The adjacency list of connected sensors can be updated quickly when a switching operation occurs, and the topology feature variable can be recalculated with the updated adjacency set.

As illustrated in **FIG. 5A,** a distribution network, for example, a radial power system **530,** includes a power source **532,** a plurality of nodes **534** and a plurality of sensors **500** to **520** at unique locations throughout radial power system **530.** Radial power system **530** may be, for example, a residential power system in which nodes **534** include loads, *e.g.*, homes, breakers, power sources, and distributed energy resources which are connected to one another by power lines **536,** *e.g.,* overhead power lines and underground cables. Sensors **500** to **520** may be located on various components throughout radial power system **530** including power source **532,** nodes **534** and power lines **536**. A direction of current flow through radial power system **530** starts at power source **532** and is identified by arrows **538** on power lines **536** carrying current to nodes **534** throughout radial power system **530.** A HiZ fault event **540** is located downstream of sensor **504.**

**FIG. 5B** illustrates a directed graph of sensors **500 to 520** after sorting by calculating the number of steps from each sensor upstream to a power source with respect to a direction of current flow. In **Fig. 5B,** sensor **500** corresponds to power source **532** so the number of steps (*i.e.*, distance) upstream to sensor **500** from each sensor **501** to **520** is determined. The number of steps is the topology rank for each sensor shown in **FIG. 5C.**

As explained above, the direction of current flow is used to linearly order sensors **501** to **520** into adjacency sets. The adjacency sets are shown schematically in **FIG. 5B.** A plurality of branches **561, 562, 563, 564, 566, 567** radiate out from sensor **500** (power source **532**). Branches **561, 562, 563** each include one sensor **500, 502, 503,** respectively, whereas branches **564, 566, 567** each include a plurality of sensors. As illustrated in **FIGS. 5A** and **5B,** the power source **532,** sensor **500,** and sensors **501** to **520** are arranged such that current flows from power source **532**/sensor **500** directly to sensor **501,** from power source 532/sensor **500** directly to sensor **502** and from power source **532**/sensor **500** directly to sensor 503 without passing any intervening sensors. Thus, each of branches **561, 562,** 563 includes one sensor. In contrast, in branch **564** current flows from power source **532**/sensor **500** to sensor **504** (**500→504**) and further downstream to sensor **505** (5044505) as the direction of current flow indicates in **FIG. 5A.** Similar to branch **564,** branches **566** and **567** include a plurality of sensors **506** to **512** and **513** to **520,** respectively. Prior to reaching sensor **512,** current passes through sensors **506** to **511** in branch **566** and prior to reaching sensor **520,** current passes through sensors **513** to **519** in branch **567.**

**FIG. 5C** illustrates a chart indicating the topology ranking and normalized topology ranking for each sensor **501** to **520.** The topology ranking is equal to the distance or number of steps upstream from each sensor **501** to **520** to sensor **500** (power source **532**). Thus, the minimum topology ranking is 1 because each sensor **501** to **520** needs at least one step to reach power source **532**/sensor **500.** To normalize the topology ranking values, each topology ranking is divided by the largest number of steps, *i.e.,* the maximum topology ranking. In this example, the largest number of steps is 8 because sensor **520** is 8 steps away from sensor **500.** Thus, each topology ranking is divided by 8 to obtain normalized values between 0 and 1.

**FIG. 6** illustrates a method **600** of sorting sensors with respect to a topology of the distribution network. An adjacency matrix or an adjacency list is generated **(610)** to identify sensors having connected edges with respect to the direction of current flow. Sorting techniques are then applied **(620)**. The sensors can be sorted **(630)** via graph sorting techniques or by calculating **(635)** the steps (*i.e.*, distance) from the sensors to the current sources. After sorting **(630)**, a ranking matrix or ranking values including the topology ranking for each sensor is output **(650)**.

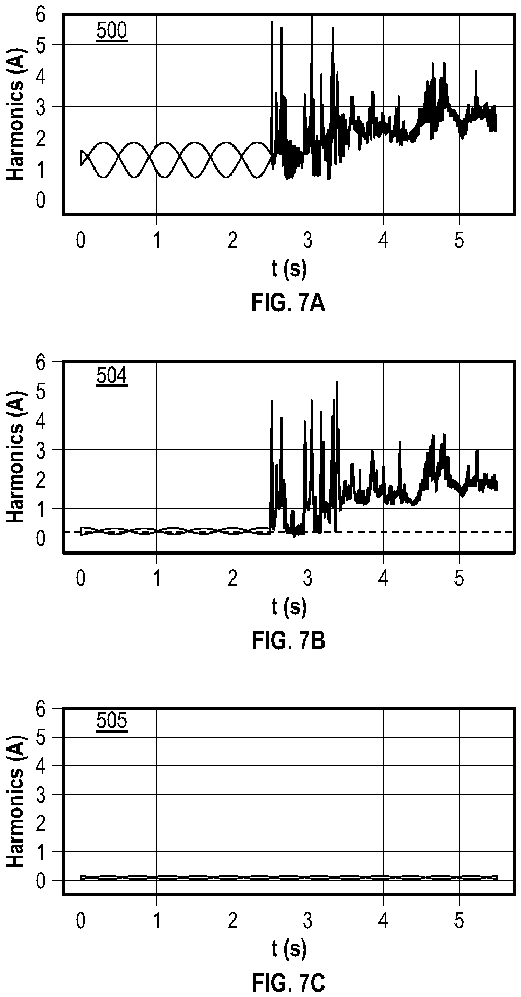

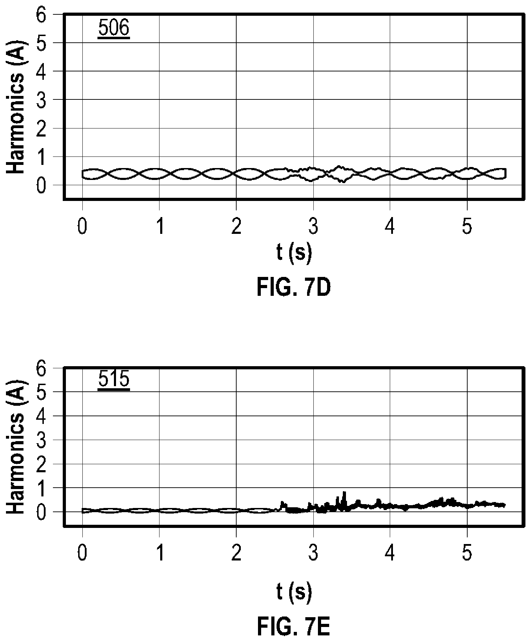

**FIGS. 7A to 7E** illustrate harmonic values over time for a plurality of sensors **500, 504, 505, 506, 515,** respectively, in radial power system **530** illustrated in **FIGS. 5A** and **5B.** Under normal operating conditions, harmonic energy values follow a sine wave pattern and establish a baseline amplitude. As explained above, a change in amplitude from the baseline amplitude is indicative of a HiZ fault event. With reference to **FIGS. 5A to 5C**, **7A and 7B**, HiZ fault event **540** is located downstream from sensors **500** and **504** and upstream from sensor **505.** The change in baseline amplitude for sensor **504** is greater than the change in baseline amplitude for sensor **500** indicating that sensor **504** is closer to the HiZ fault location. With respect to sensor **504,** a significant change in baseline amplitude occurs at around 2.5 seconds. The baseline amplitude at sensor **504** is less than 0.5A from 0 to 2.5 seconds and increases to about 4.5A from 2.5 to 3.5 seconds for an approximate change in amplitude of 4A, whereas in **FIG. 7A,** the baseline amplitude at sensor **500** is slightly greater than 1.0A from 0 to 2.5 seconds and increases to about 4.5A for an approximate change of 3.5A. As illustrated in **FIGS. 7A and 7B** and in accordance with the present disclosure, larger changes in baseline amplitude indicate that sensor **504** is closer to the HiZ fault event **540** than sensor **500.** As illustrated in **FIGS. 7C to 7E,** the baseline amplitudes of sensors **505, 506 and 515** remain relatively unchanged despite the HiZ fault event **540** because sensor **505** is downstream from the HiZ fault event **540 (FIGS. 5A and 5B)** and sensors **506, 515 are** in different branches **566, 567,** respectively, than HiZ fault event **540 (FIG. 5B)** and thus are not in the direction of current flow. Thus, **FIGS. 7A to 7E** show that significant changes in the baseline amplitude occur in in sensors upstream from a HiZ fault event and that baseline amplitudes remain unchanged in sensors downstream from the HiZ fault event and in sensors in other branches of current flow.

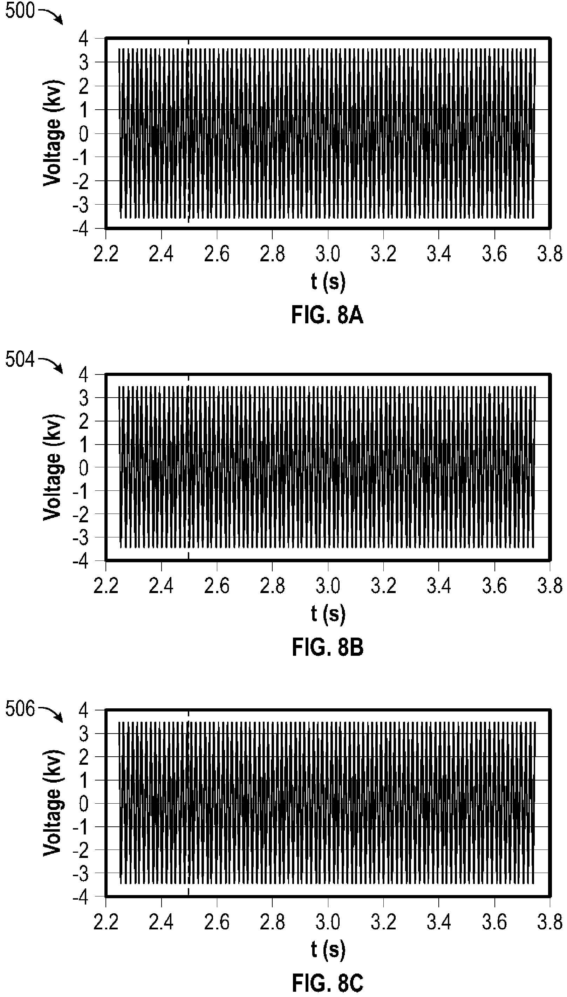

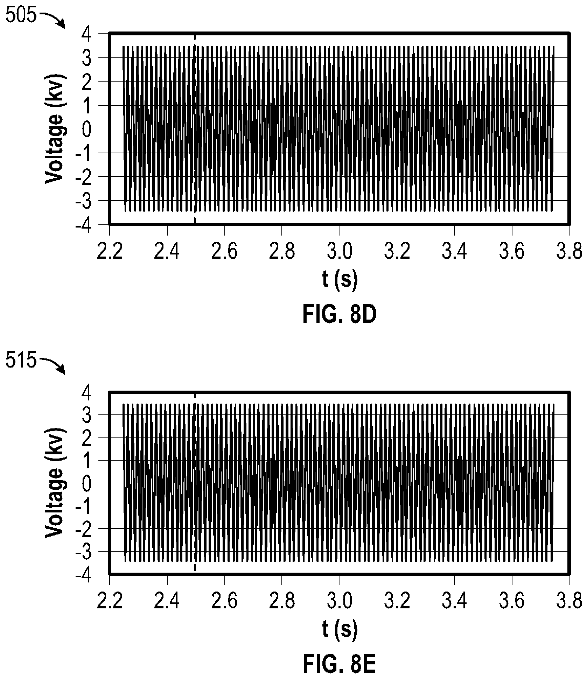

**FIGS. 8A to 8E** illustrate voltage over time for a plurality of sensors **500, 504, 506, 505, 515,** respectively, in radial power system **530** illustrated in **FIGS. 5A and 5B.** As shown, there is no change in voltage detected in any of sensors **500, 504, 506, 505, 515,** despite a HiZ fault event **540** occurring at 2.5 seconds. No change is detected in sensors **500, 504** downstream from HiZ fault event **540,** no change is detected in sensor **505** upstream from HiZ fault event **540,** and no change is detected in sensors **506, 515** located in different branches of current flow. Thus, changes in voltage cannot be relied on to locate HiZ fault events in distribution systems.

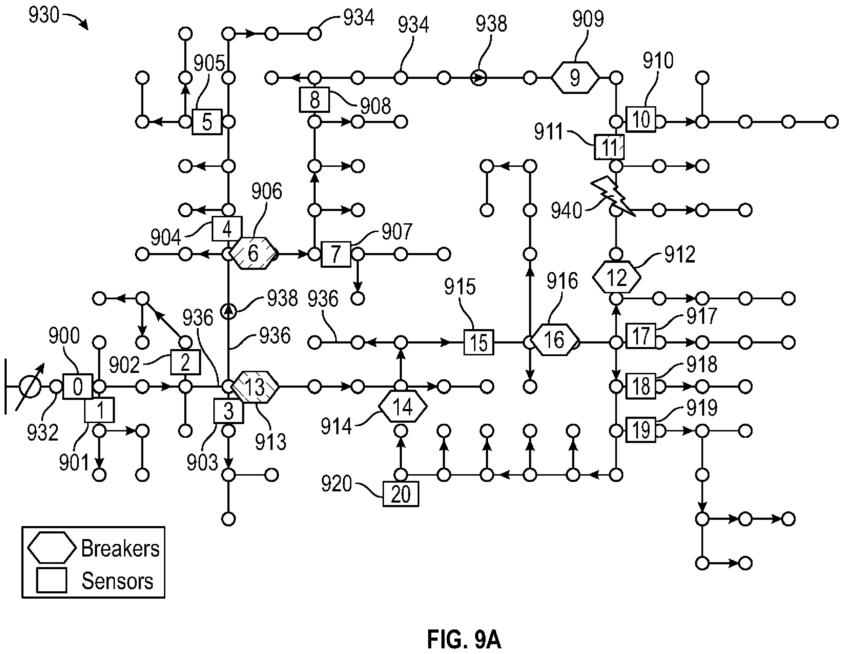

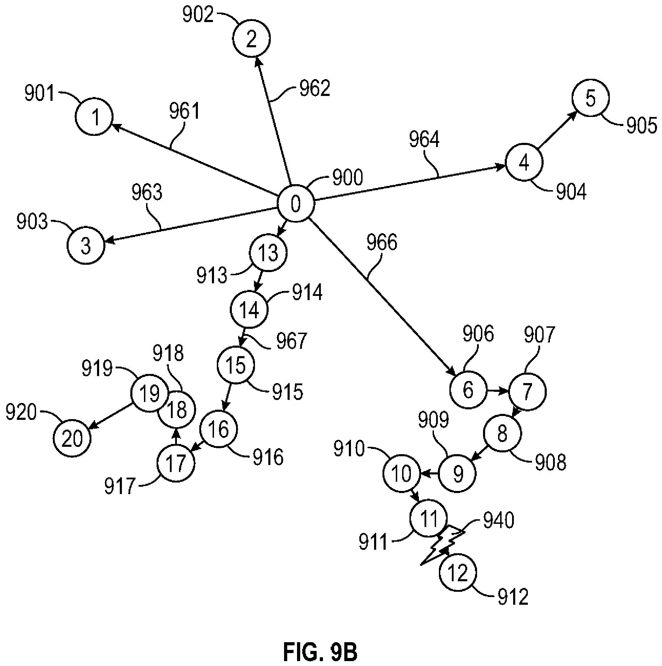

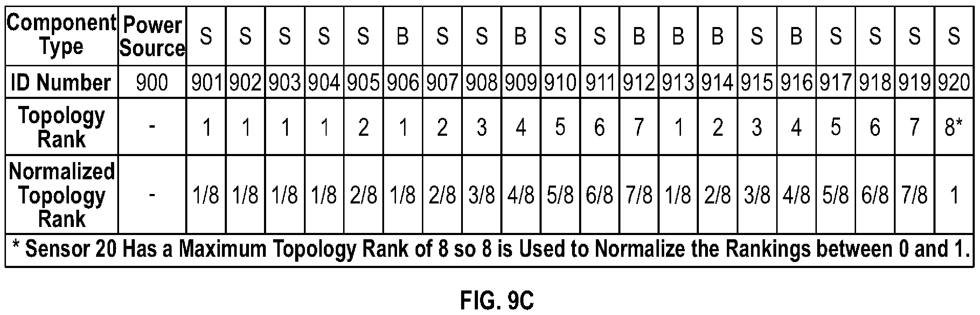

**FIG. 9A** illustrates a topology of a distribution network having a plurality of nodes, **FIG. 9B** illustrates a schematic diagram of a plurality of sensors shown in **Fig. 9A** after sorting and **FIG. 9C** is a chart illustrating topology rankings and normalized topology rankings for each sensor.

As illustrated in **FIG. 9A,** a distribution network, for example, a radial power system **930,** includes a power source **932,** a plurality of nodes **934** and a plurality of sensors **900** to **920** at unique locations. Sensors are located on various components throughout radial power system **930** including power source **932,** nodes **934,** breakers **906, 909, 912, 913, 914, 916,** and power lines **936.** The breakers also include sensing components that record currents and/or voltages. A direction of current flow through radial power system **930** starts at power source **932** and is identified by arrows **938** on power lines **936** carrying current to nodes **934.** A HiZ fault event **940** is located downstream of sensor **911** and upstream of breaker **912.**

**FIG. 9B** illustrates a schematic diagram of sensors **900** to **920** after sorting by calculating the number of steps from each sensor upstream to a power source with respect to a direction of current flow. Sensor **900** corresponds to power source **932** so the number of steps (*i.e.*, distance) upstream to sensor **900** from each sensor **901** to **920** is determined. The number of steps is the topology ranking as shown in **FIG. 9C.**

As explained above, the direction of current flow is used to linearly order sensors **901** to **920** into adjacency sets shown schematically in **FIG. 9B.** Branches **961, 962, 963, 964, 966, 967** radiate out power source **932** (sensor **900)** representing six different directions of current flow. Within each branch, current must flow through each sensor to reach the next sensor downstream. Branches **961, 962, 963** each include one sensor **901, 902, 903,** respectively, so current flows from power source **932** directly to the respective sensor. Since each sensor **901, 902, 903** is only one step away from power source **932**/sensor **900,** sensors **901, 902, 903** each have a topology ranking of 1. Branches **964, 966, 967** each include a plurality of sensors so current flows from power source **932** through each consecutive sensor to reach the furthest downstream sensor. In branch **964,** current flows from power source **932** to sensor **904** (**900→904**) and further downstream to sensor **905** (**904→905**). In branch **966,** current flows from power source **932,** through sensors **906** to **911** to reach downstream sensor **912.** Similarly, in branch **967,** current flows from power source **932,** through sensors **913** to **919** to reach downstream sensor **920.**

**FIG. 9C** illustrates a chart indicating the topology ranking and normalized topology ranking for each sensor **901** to **920.** The topology ranking is equal to the distance or number of steps upstream from each sensor **901** to **920** to sensor **900** (power source **932).** Thus, the minimum topology ranking is 1 because each sensor **901** to **920** needs at least one step to reach power source **932**/sensor **900.** To normalize the topology ranking values, each topology ranking is divided by the largest number of steps, *i.e.,* the maximum topology ranking. In this example, the largest number of steps is 8 because sensor **920** is 8 steps away from sensor **900.** Thus, each topology ranking is divided by 8 to obtain normalized values between 0 and 1.

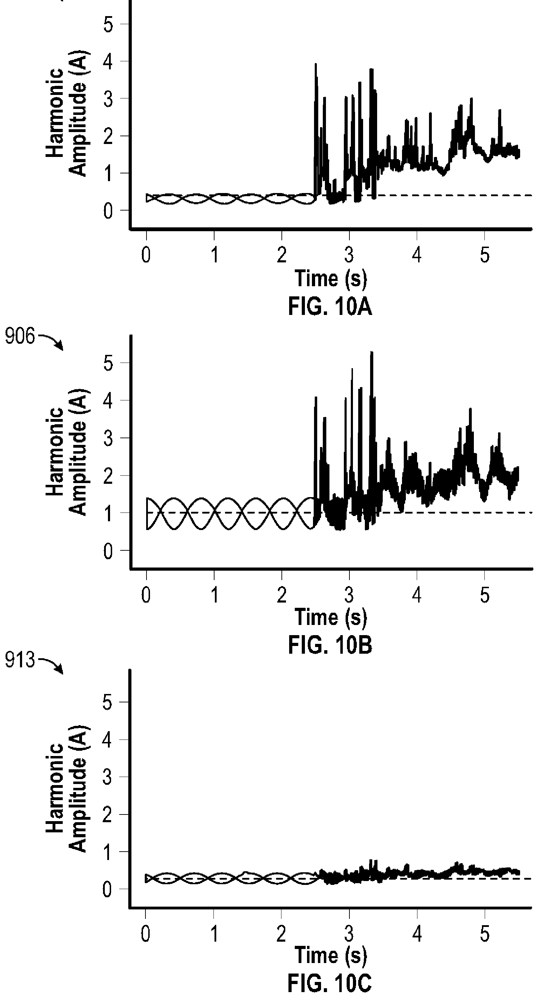

**FIGS. 10A to 10C** illustrate harmonic values over time for a plurality of sensors in **911, 906, 913,** respectively, in radial power system **930** of **FIGS. 9A and 9B.** With reference to **FIGS. 9A, 9B, 9C and 10A to 10C** , sensors **906** and **911** and HiZ fault are located in branch **965.** HiZ fault is downstream from both sensors **906** and **911.** Sensor **913** is located in a different branch **967** and thus is not located upstream nor downstream from HiZ fault event **940.**

As explained above, a change in harmonic amplitude from the baseline harmonic amplitude is indicative of a HiZ fault event. As illustrated in **FIG. 10A,** a significant change in baseline harmonic amplitude occurs at around 2.5 seconds for sensor **911,** the sensor directly upstream from HiZ fault event **940.** The baseline amplitude at sensor **911** is about 0.33A from 0 to 2.5 seconds and increases to about 3.5A from 2.5 to 3.5 seconds for an approximate change in amplitude of 3.17A, whereas in **FIG. 10B,** the baseline amplitude at sensor **906** is about 1.0A from 0 to 2.5 seconds and increases to about 4A for an approximate change of 3A. In accordance with the present disclosure, the larger change in baseline amplitude shown in **FIG. 10A** indicates that sensor **911** is closer to a location of HiZ fault event **940.** In addition, as expected, the baseline amplitude of sensor **913** does not include any significant changes in baseline harmonic amplitude indicative of HiZ fault event **940** because sensor **913** is in a different branch than HiZ fault event **940.** Thus, **FIGS. 10A to 10C** show that significant changes in the baseline amplitude occur in sensors upstream from a HiZ fault event and that baseline amplitudes remain unchanged in sensors in other branches of current flow.

To isolate HiZ fault event **940** in radial power system **930,** the nearest upstream breaker **909** would be opened to prevent current from flowing to the HiZ fault location.

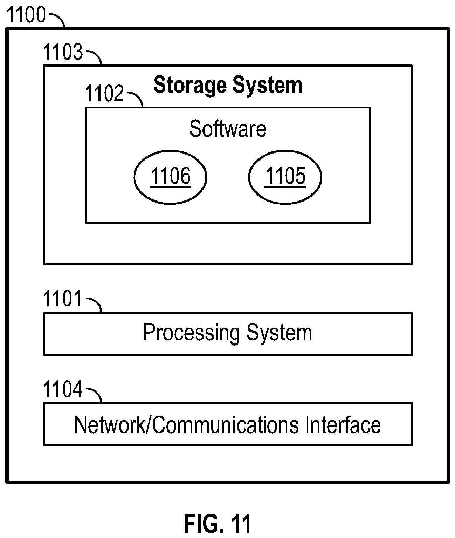

**FIG. 11** illustrates components of a computing system that may be used in certain embodiments described herein. Referring to **FIG. 11,** system **1100** may be implemented within a single computing device or distributed across multiple computing devices or sub-systems that cooperate in executing program instructions. In some cases, system **1100** can be a firewall hardware device, router, or other computing system on a network. In general, system **1100** can include one or more blade server devices, standalone server devices, personal computers, routers, hubs, switches, bridges, firewall devices, intrusion detection devices, mainframe computers, network-attached storage devices, and other types of computing devices.

The system **1100** can include a processing system **1101,** which may include one or more processors and/or other circuitry that retrieves and executes software **1102** from storage system **1103.** Processing system **1101** may be implemented within a single processing device but may also be distributed across multiple processing devices or sub-systems that cooperate in executing program instructions.

Storage system(s) **1103** can include any computer readable storage media readable by processing system **1101** and capable of storing software **1102.** Storage system **1103** may be implemented as a single storage device but may also be implemented across multiple storage devices or sub-systems co-located or distributed relative to each other. Storage system **1103** may include additional elements, such as a controller, capable of communicating with processing system **1101.** Storage system **1103** may also include storage devices and/or sub-systems on which data is stored. System **1100** may access one or more storage resources in order to access information to carry out any of the processes indicated by software **1102.**

Software **1102,** including routines for performing processes, may be implemented in program instructions and among other functions may, when executed by system **1100** in general or processing system **1101** in particular, direct the system **1100** or processing system **1101** to operate as described herein. For example, software **1102** can include, but is not limited to, instructions for methods **300** and **600.** These methods are depicted by applications **1105, 1106** in **FIG. 11.**

In embodiments where the system **1100** includes multiple computing devices, the server can include one or more communications networks that facilitate communication among the computing devices. For example, the one or more communications networks can include a local or wide area network that facilitates communication among the computing devices. One or more direct communication links can be included between the computing devices. In addition, in some cases, the computing devices can be installed at geographically distributed locations. In other cases, the multiple computing devices can be installed at a single geographic location, such as a server farm or an office.

A communication interface **1104** may be included, providing communication connections and devices that allow for communication between system **1100** and other computing systems (not shown) over a communication network or collection of networks (not shown) or the air.

In some embodiments, system **1100** may host one or more virtual machines.

Alternatively, or in addition, the functionality, methods, and processes described herein can be implemented, at least in part, by one or more hardware modules (or logic components). For example, the hardware modules can include, but are not limited to, application-specific integrated circuit (ASIC) chips, field programmable gate arrays (FPGAs), system-on-a-chip (SoC) systems, complex programmable logic devices (CPLDs) and other programmable logic devices now known or later developed. When the hardware modules are activated, the hardware modules perform the functionality, methods and processes included within the hardware modules.

It should be understood that as used herein, in no case do the terms "storage media," "computer-readable storage media" or "computer-readable storage medium" consist of transitory carrier waves or propagating signals.

Instead, "storage" media refers to non-transitory media.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts that would be recognized by one skilled in the art are intended to be within the scope of the claims.

## Claims

1. A method (300) for locating a high impedance fault event location in a distribution system (100) comprising the steps of:

   determining (320) a topology ranking for each of a plurality of sensors (112) in a distribution system (100);
   receiving (330) an alarm (244) at a central processor (152, 252) indicating a high impedance fault event;
   transmitting (340) a request for data associated with the high impedance fault event to the plurality of sensors (112) and a plurality of edge processing devices (132, 232) in the distribution system (100);
   receiving (350) the requested data from the edge processing devices (132, 232); and
   determining (360) a relative location of the high impedance fault event with respect to one of the plurality of sensors using the requested data and the topology ranking.

2. The method of claim 1, wherein the relative location of the high impedance fault event is determined with respect to a sensor upstream from the high impedance fault event with respect to a direction of current flow in the distribution system.

3. The method of claim 1 or 2, further comprising:
   transmitting a command (268) to open a breaker in the distribution system to isolate (370) the high impedance fault event.

4. The method of claim 3, wherein the breaker is upstream from the high impedance fault event with respect to a direction of current flow in the distribution system.

5. The method of any preceding claim, further comprising:

   computing a detection time, a detection duration, a mean harmonic amplitude change, and a high impedance detection status for a period of time from the requested data,
   wherein the requested data includes current timeseries data or voltage timeseries data collected by the plurality of sensors, wherein detection time, detection duration, a mean harmonic amplitude change are each normalized for a maximum value recorded by the plurality of sensors.

6. The method of claim 5, wherein a machine learning model uses the topology ranking, detection time, detection duration, mean harmonic amplitude change, and high impedance detection status as features to determine the relative location of the high impedance fault event.

7. The method of any preceding claim, wherein Equation (1) is used to determine the relative location of the high impedance fault event, wherein f is a location metric value for each sensor:

$$Eq\ (1) \quad f = Hiz\ detection\ status \times \sqrt{mean\ harmonics} \times \frac{1}{detection\ time} \times$$

$$detection\ duration \times topology\ ranking^2 .$$

8. The method of claim 7, wherein the location metric value $f$ is calculated for each sensor and a highest location metric value $f$ indicates the sensor that is closest to and upstream from the high impedance fault event.

9. The method of any preceding claim, wherein the high impedance fault event is detected based on changes in amplitudes of harmonic energy values and wherein mean harmonics is a mean value of relative changes in amplitudes of harmonic energy values during the high impedance fault event.

10. The method of any preceding claim, wherein the topology ranking indicates a relative distance of each sensor from a current source with respect to a direction of current flow in the distribution system.

11. The method of any preceding claim, wherein determining a topology ranking for each of the plurality of sensors in the distribution system comprises:

generating (610) an adjacent matrix or an adjacent list for the plurality of sensors based on a direction of current flow in the distribution system;
sorting (620) the plurality of sensors in the distribution system; and
outputting (650) the topology ranking for each sensor in the distribution system.

12. The method of claim 11, further comprising:

monitoring the direction of current flow for changes in real-time; and
generating a further adjacent matrix or a further adjacent list, respectively, for the plurality of sensors when the direction of current flow changes.

13. The method of claim 11 or 12, wherein sorting (620) the plurality of sensors includes:

using a graph sorting method (630) to sort the plurality of sensors in the distribution system with respect to the direction of current flow; or
calculating (635) a relative distance to a current source for each sensor in the distribution system with respect to the direction of current flow.

14. A radial power system comprising:

at least one power source;
a plurality of sensors, each sensor positioned at a unique location within the radial power system, each sensor calculating harmonic energy values based on detected electrical signals;
a plurality of edge processing devices, each edge processing device connected to at least one sensor, each edge processing device configured to detect a high impedance fault event within the radial power system based on the harmonic energy values received from the sensors; and
a central processor, the plurality of edge processing devices connected to the central processor, the central processor configured to perform the method of any of claims 1-13.

15. The radial power system of claim 14, wherein the plurality of sensors continually send data including current direction, current amplitude, current magnitude, and breaker status to the edge processing devices and central processor for detection of the high impedance fault event and determining the topology ranking.

FIG. 1

FIG. 2A

FIG. 2B

300

**320** — Determining a topology ranking for each of the plurality of sensors in the distribution grid

**330** — Receiving an alarm indicating a fault event

**340** — Transmitting a request for data associated with fault event

**350** — Receiving requested data

**360** — Determining a relative location of the fault event using the requested data and the topology ranking

**370** — Isolating the fault event in the distribution grid

**FIG. 3**

FIG. 4A

Mean Harmonics

FIG. 4B

## 1 / Detection Time

FIG. 4C

## Detection Duration

FIG. 4D

FIG. 4E

| | Sensors that Not in the Current Flow as Fault |
| | Sensors that in the Upstream of the Fault Location |
| | Sensors that in the Downstream of the Fault Location |

**FIG. 5A**

y

| Component | Power Source | S | S | S | S | S | S | S | S | B | S | S | B | B | B | S | B | S | S | S | B |
|---|---|---|---|---|---|---|---|---|---|---|---|---|---|---|---|---|---|---|---|---|---|
| ID No. | 0 | 1 | 2 | 3 | 4 | 5 | 6 | 7 | 8 | 9 | 10 | 11 | 12 | 13 | 14 | 15 | 16 | 17 | 18 | 19 | 20 |
| Topology Rank | - | 1 | 1 | 1 | 1 | 2 | 1 | 2 | 3 | 4 | 5 | 6 | 7 | 1 | 2 | 3 | 4 | 5 | 6 | 7 | 8* |
| Normalized Topology Rank | - | 1/8 | 1/8 | 1/8 | 1/8 | 2/8 | 1/8 | 2/8 | 3/8 | 4/8 | 5/8 | 6/8 | 7/8 | 1/8 | 2/8 | 3/8 | 4/8 | 5/8 | 6/8 | 7/8 | 1 |

\* Sensor 20 Has a Maximum Topology Rank of 8 so 8 is Used to Normalize the Rankings between 0 and 1.

FIG. 5C

EP 4 722 740 A1

600

610
Generating adjacency matrix
or adjacency list based on
current flow direction

620
Sorting
?

630
Graph sorting

635
Calculating steps to current
sources

650
Outputting ranking matrix
or ranking values for
each sensor

FIG. 6

FIG. 7A

FIG. 7B

FIG. 7C

FIG. 7D

FIG. 7E

500

FIG. 8A

504

FIG. 8B

506

FIG. 8C

FIG. 8D

FIG. 8E

**FIG. 9B**

| Component Type | Power Source | S | S | S | S | S | B | S | S | B | S | S | B | B | B | S | B | S | S | S | S |
|---|---|---|---|---|---|---|---|---|---|---|---|---|---|---|---|---|---|---|---|---|---|---|
| ID Number | 900 | 901 | 902 | 903 | 904 | 905 | 906 | 907 | 908 | 909 | 910 | 911 | 912 | 913 | 914 | 915 | 916 | 917 | 918 | 919 | 920 |
| Topology Rank | - | 1 | 1 | 1 | 1 | 2 | 1 | 2 | 3 | 4 | 5 | 6 | 7 | 1 | 2 | 3 | 4 | 5 | 6 | 7 | 8* |
| Normalized Topology Rank | - | 1/8 | 1/8 | 1/8 | 1/8 | 2/8 | 1/8 | 2/8 | 3/8 | 4/8 | 5/8 | 6/8 | 7/8 | 1/8 | 2/8 | 3/8 | 4/8 | 5/8 | 6/8 | 7/8 | 1 |
| * Sensor 20 Has a Maximum Topology Rank of 8 so 8 is Used to Normalize the Rankings between 0 and 1. | | | | | | | | | | | | | | | | | | | | | |

FIG. 9C

EP 4 722 740 A1

FIG. 10A

FIG. 10B

FIG. 10C

1100

1103

**Storage System**

1102

Software

( 1106 )   ( 1105 )

1101

Processing System

1104

Network/Communications Interface

**FIG. 11**

## EUROPEAN SEARCH REPORT

**Application Number**

EP 25 15 1916

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CUI QIUSHI ET AL: "Mining Partially Labeled Data from Edge Devices to Detect and Locate High Impedance Faults", 2019 IEEE SUSTAINABLE POWER AND ENERGY CONFERENCE (ISPEC), IEEE, 21 November 2019 (2019-11-21), pages 2170-2175, XP033698978, DOI: 10.1109/ISPEC48194.2019.8974897 [retrieved on 2020-01-29] * the whole document * | 1-15 | INV. G01R19/25 G01R31/08 G01R31/52 |
| A | MANSOURLAKOURAJ MOHAMMAD ET AL: "Event Classification in Active Distribution Grids Using Physics-Informed Graph Neural Network and PMU Measurements", 2022 IEEE INDUSTRY APPLICATIONS SOCIETY ANNUAL MEETING (IAS), IEEE, 9 October 2022 (2022-10-09), pages 1-6, XP034229082, DOI: 10.1109/IAS54023.2022.9939922 [retrieved on 2022-11-17] * the whole document * | 1-15 | |
| A | US 9 160 158 B2 (SCHWEITZER ENGINEERING LAB INC [US]) 13 October 2015 (2015-10-13) | 1-15 | TECHNICAL FIELDS SEARCHED (IPC) G01R H02J H02H |

The present search report has been drawn up for all claims

| Place of search | Date of completion of the search | Examiner |
|---|---|---|
| Munich | 20 June 2025 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 4 722 740 A1

## ANNEX TO THE EUROPEAN SEARCH REPORT
## ON EUROPEAN PATENT APPLICATION NO.

EP 25 15 1916

This annex lists the patent family members relating to the patent documents cited in the above-mentioned European search report.
The members are as contained in the European Patent Office EDP file on
The European Patent Office is in no way liable for these particulars which are merely given for the purpose of information.

20-06-2025

| Patent document cited in search report | | Publication date | Patent family member(s) | Publication date |
|---|---|---|---|---|
| US 9160158 | B2 | 13-10-2015 | AU 2013328964 A1 | 09-04-2015 |
| | | | BR 112015007824 A2 | 04-07-2017 |
| | | | CA 2885185 A1 | 17-04-2014 |
| | | | US 2014104738 A1 | 17-04-2014 |
| | | | WO 2014059371 A1 | 17-04-2014 |

EPO FORM P0459

For more details about this annex : see Official Journal of the European Patent Office, No. 12/82

33

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2024063777 W

- EP 2024063756 W